# EUROPEAN PATENT APPLICATION

(11) **EP 4 333 000 A1**
(43) Date of publication of application: **06.03.2024**
(21) Application number: 22795699.2
(22) Date of filing: 22.04.2022
(51) Int. Cl.: H01G 4/06, H01G 9/00, H01G 9/07

(54) **CAPACITOR, METHOD FOR MANUFACTURING CAPACITOR, ELECTRIC CIRCUIT, CIRCUIT BOARD, AND DEVICE**

(30) Priority: 28.04.2021 JP 2021076880
(71) Applicant: Panasonic Intellectual Property Management Co., Ltd., Kadoma-shi, Osaka 571-0057 (JP)
(72) Inventor: KANOU, Manabu, Kadoma-shi, Osaka 571-0057 (JP); KATO, Yuya, Kadoma-shi, Osaka 571-0057 (JP)
(74) Representative: Eisenführ Speiser
(86) International application number: PCT/JP2022/018644
(87) International publication number: WO 2022/230786

(57) **Abstract**

A capacitor 1a of the present disclosure includes a first electrode 11, a second electrode 12, and a dielectric 20. The dielectric 20 is placed between the first electrode 11 and the second electrode 12. The dielectric 20 includes a first layer 21 and a second layer 22. The first layer 21 includes a diamine. The second layer 22 includes tin(IV) sulfide. The first layer 21 and the second layer 22 are stacked alternately in a particular direction intersecting a surface 11a of the first electrode 21 facing the second electrode 12. An electrical conductivity of the dielectric 20 in the particular direction at 25°C is 1 × 10⁻¹⁰ S/cm or less.

## Description

### TECHNICAL FIELD

The present invention relates to a capacitor, a capacitor production method, an electrical circuit, a circuit board, and an apparatus.

### BACKGROUND ART

Intercalation of diamines into SnS₂ have been performed.

For example, Non Patent Literature 1 shows the result of AC impedance measurement of a sample obtained by intercalation of an alkyldiamine such as ethylenediamine or propylenediamine into single-crystal SnS₂. According to the measurement result, the bulk electrical conductivity of the sample at room temperature is approximately 7 × 10⁻⁹ S/cm.

Non Patent Literature 2 describes a method for intercalating ethylenediamine, p-phenylenediamine, or 1,5-naphthalenediamine into SnS₂. Optical properties of a sample produced by this method are measured in Non Patent Literature 2. However, Non Patent Literature 2 fails to describe electrical-conduction-related properties, such as impedance properties, of the sample.

### CITATION LIST

### Non Patent Literature

Non Patent Literature 1: Morales, Julian, et al. "Synthesis and characterization of diamine intercalation compounds of SnS2 single crystals." Journal of Solid State Chemistry 150.2 (2000): 391-398
Non Patent Literature 2: Toh, M. L., et al. "Intercalation of organic molecules into SnS2 single crystals." Journal of Solid State Chemistry 198 (2013): 224-230

### SUMMARY OF INVENTION

### Technical Problem

Non Patent Literatures 1 and 2 explore only materials obtained by intercalation of diamines into SnS₂, and fail to specifically explore capacitors. The present disclosure therefore provides a new capacitor.

### Solution to Problem

The present disclosure provides a capacitor including:
a first electrode;
a second electrode; and
a dielectric placed between the first electrode and the second electrode, wherein
the dielectric includes a first layer including a diamine and a second layer including tin(IV) sulfide,
the first layer and the second layer are stacked alternately in a particular direction intersecting a surface of the first electrode facing the second electrode, and
an electrical conductivity in the particular direction at 25°C is 1 × 10⁻¹⁰ S/cm or less.

### Advantageous Effects of Invention

According to the present disclosure, a new capacitor can be provided.

### BRIEF DESCRIPTION OF DRAWINGS

FIG. 1 shows a dielectric according to an embodiment of the present disclosure.
FIG. 2 is a cross-sectional view schematically showing the capacitor according to an embodiment of the present disclosure.
FIG. 3A schematically shows an electrical circuit according to an embodiment of the present disclosure.
FIG. 3B schematically shows a circuit board according to an embodiment of the present disclosure.
FIG. 3C schematically shows an apparatus according to an embodiment of the present disclosure.
FIG. 4 is a flowchart showing an example of a dielectric production method according to an embodiment of the present disclosure.
FIG. 5 shows results of measuring and calculating X-ray diffraction (XRD) patterns of single-crystal SnS₂ and a specimen according to Example.
FIG. 6 shows FTIR spectra of gases generated by heating the specimen according to Example at 100°C, 200°C, 300°C, and 400°C.
FIG. 7A shows a Nyquist plot obtained from an AC impedance measurement result for the specimen according to Example.
FIG. 7B shows an equivalent circuit used for fitting in FIG. 7A.
FIG. 8 is a graph showing a relation between an electrical conductivity of the specimen according to Example in a thickness direction thereof and a frequency of AC voltage.
FIG. 9 is a graph showing a relation between a dielectric constant of the specimen according to Example and a frequency of AC voltage.

### DESCRIPTION OF EMBODIMENTS

### (Findings on which the present disclosure is based)

It is conceivable to use, as a dielectric of a capacitor, a material including a layered compound including an organic compound. It is conceivable to use, for example, a material obtained by intercalation of an organic compound such as a diamine into tin(IV) sulfide. The organic compound such as a diamine has, for example, a Lewis base such as nitrogen. This can cause an electron inflow from a lone pair of the organic compound to the tin(IV) sulfide.

Since ethylenediamine is miscible, for example, with water, a dielectric produced using ethylenediamine can contain moisture. The moisture donates a proton to a lone electron pair of the ethylenediamine, thereby cationizing the ethylenediamine. The resulting cation is present between SnS₂ layers to generate an electrically conductive carrier. The dielectric can have a high electrical conductivity owing to the electrically conductive carrier. Consequently, current leakage tends to occur in a capacitor including the dielectric.

In Non Patent Literature 1, binding energy for intercalation of ethylenediamine into SnS₂ is measured by X-ray photoelectron spectroscopy. According to Non Patent Literature 1, intercalation of ethylenediamine into single-crystal SnS₂ changes an electronic state of sulfur included in the SnS₂ and nitrogen included in the ethylenediamine.

According to Non Patent Literature 1, heating a sample obtained by intercalation of an alkyldiamine such as ethylenediamine or propylenediamine into single-crystal SnS₂ generates hydrogen sulfide H₂S at around 200°C and a higher temperature. According to Non Patent Literature 1, the H₂S is generated by a reaction of sulfur included in SnS₂ and water. This indicates that, the compound obtained in Non Patent Literature 1 by intercalation of ethylenediamine into SnS₂ contains moisture.

In Non Patent Literature 1, intercalation of ethylenediamine into SnS₂ is performed in the following manner. First, inside a glove box, 200 mg of single-crystal SnS₂ and 2 milliliters (mL) of ethylenediamine are put in a Pyrex glass tube, which is then closed. Next, the Pyrex glass tube is heated at 180°C to obtain a sample in which ethylenediamine has been intercalated in single-crystal SnS₂. The sample is taken out of the glass tube and washed with acetonitrile. A sample in which ethylenediamine has been intercalated in SnS₂ is obtained in this manner.

Non Patent Literature 1 describes neither removing moisture on the glass tube before putting the single-crystal SnS₂ and the ethylenediamine in the Pyrex glass tube nor freeze-drying the SnS₂ and the ethylenediamine.

In Non Patent Literature 2, for example, intercalation of ethylenediamine into SnS₂ is performed in the following manner. First, SnS₂ and ethylenediamine are put in the glass tube at a molar ratio of SnS₂:ethylenediamine = 1:10. The glass tube is closed with a plastic cap. Next, the glass tube is heated at 150°C to obtain a sample in which ethylenediamine has been intercalated in SnS₂. The sample is taken out of the glass tube and washed with acetone. After that, a drying treatment is performed in a vacuum oven at 80°C.

The glass tube and the plastic cap are used as a closed container in Non Patent Literature 2, and it is difficult to say that the container is sealed hermetically. Therefore, moisture is thought to be included inside the container according to the intercalation method described in Non Patent Literature 2. Therefore, the compound obtained in Non Patent Literature 2 by intercalation of ethylenediamine into SnS₂ is thought to contain moisture.

As described above, it is thought that moisture in a layered compound obtained by intercalation of an organic compound such as a diamine into tin(IV) sulfide tends to cause current leakage in a capacitor. In view of such a circumstance, the present inventors made intensive studies to create a capacitor capable of reducing current leakage. Through a lot of trial and error, the present inventors have finally devised a capacitor of the present disclosure.

### (Summary of one aspect according to the present disclosure)

A capacitor according to a first aspect of the present disclosure includes:
a first electrode;
a second electrode; and
a dielectric placed between the first electrode and the second electrode, wherein
the dielectric includes a first layer including a diamine and a second layer including tin(IV) sulfide,
the first layer and the second layer are stacked alternately in a particular direction intersecting a surface of the first electrode facing the second electrode, and
an electrical conductivity in the particular direction at 25°C is 1 × 10⁻¹⁰ S/cm or less.

According to the first aspect, the electrical conductivity of the dielectric in the particular direction at 25°C is 1 × 10⁻¹⁰ S/cm or less. Because of this, current leakage in the capacitor including this dielectric is likely to be reduced.

According to a second aspect of the present disclosure, for example, in the capacitor according to the first aspect, the tin(IV) sulfide may be a single crystal. According to the second aspect, current leakage in the capacitor is likely to be reduced.

According to a third aspect of the present disclosure, for example, in the capacitor according to the first or second aspect, the diamine may include ethylenediamine. According to the third aspect, the first layer and the second layer are easily stacked alternately.

According to a fourth aspect of the present disclosure, for example, in the capacitor according to any one of the first to third aspects, the first electrode, the dielectric, and the second electrode may be placed in this order in the particular direction. According to the fourth aspect, current leakage in the capacitor is likely to be reduced.

A capacitor production method according to a fifth aspect of the present disclosure includes:
obtaining a dielectric by putting a diamine and tin(IV) sulfide in a container and performing a heating treatment of the container to form a first layer including the diamine and a second layer including the tin(IV) sulfide and stacked alternately with the first layer, and
placing the dielectric between a first electrode and a second electrode by adding the first electrode and the second electrode to be in contact with the dielectric, wherein
the method further includes at least one selected from the group consisting of performing a vacuum desiccation treatment of the container before the diamine and the tin(IV) sulfide are put in the container and performing a cooling drying treatment of the diamine and the tin(IV) sulfide before the heating treatment.

According to the fifth aspect, the amount of moisture included in the dielectric can be decreased, which makes it possible to produce a capacitor advantageous in terms of reducing current leakage.

According to a sixth aspect of the present disclosure, for example, in the capacitor production method according to the fifth aspect, the vacuum desiccation treatment may include adjusting an environment of the container to a pressure of 10 Pa or lower and a temperature of 300°C or higher. According to the sixth aspect, the amount of moisture included in the dielectric can be decreased further.

According to a seventh aspect of the present disclosure, for example, in the capacitor production method according to the fifth or sixth aspect, the cooling drying treatment may include adjusting an environment of the diamine and the tin(IV) sulfide to a pressure of 10 Pa or lower at a temperature equal to or lower than a melting point of the diamine. According to the seventh aspect, the amount of moisture coexistent with the diamine can be decreased.

According to an eighth aspect of the present disclosure, for example, in the capacitor production method according to any one of the fifth to seventh aspects, the diamine and the tin(IV) sulfide may be cooled to a temperature equal to or lower than a melting point of the diamine in the cooling drying treatment. According to the eighth aspect, the amount of moisture coexistent with the diamine and the tin(IV) sulfide can be decreased.

According to a ninth aspect of the present disclosure, for example, in the capacitor production method according to any one of the fifth to eighth aspects, a temperature of the container may be maintained in a temperature range of 140°C or higher and 220°C or lower for 15 minutes or more and 60 minutes or less in the heating treatment. According to the ninth aspect, it is possible to form the first layer and the second layer efficiently.

An electrical circuit according to a tenth aspect of the present disclosure includes the capacitor according to any one of the first to fourth aspects. According to the tenth aspect, current leakage in the capacitor is likely to be reduced, and thus properties of the electrical circuit are likely to be improved.

A circuit board according to an eleventh aspect of the present disclosure includes the capacitor according to any one of the first to fourth aspects. According to the eleventh aspect, current leakage in the capacitor is likely to be reduced, and thus properties of the circuit board are likely to be improved.

An apparatus according to a twelfth aspect of the present disclosure includes the capacitor according to any one of the first to fourth aspects. According to the twelfth aspect, current leakage in the capacitor is likely to be reduced, and thus properties of the apparatus are likely to be improved.

### (Embodiments)

Embodiments of the present disclosure will be described hereinafter with reference to the drawings. The present disclosure is not limited to the following embodiments.

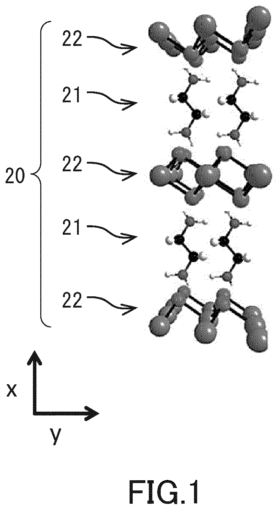

FIG. 1 shows a dielectric according to an embodiment of the present disclosure. In FIG. 1, the x axis and the y axis are mutually orthogonal. A dielectric 20 includes a first layer 21 and a second layer 22. The first layer 21 and the second layer 22 are stacked alternately in a particular direction (x axis direction). The first layer 21 is a layer including a diamine. The second layer 22 is a layer including tin(IV) sulfide SnS₂. An electrical conductivity of the dielectric 20 in the particular direction at 25°C is 1 × 10⁻¹⁰ S/cm or less. With such structural features, the SnS₂ responds to an electric field upon application of voltage and causes a charge to transfer in the second layer 22. At the same time, the first layer 21 prevents a charge from transferring. This is likely to increase the dielectric constant of the dielectric 20 and the capacitance of a capacitor including the dielectric 20. Such a layered structure of the dielectric 20 can be formed, for example, by intercalation of a diamine between SnS₂ layers weakly bonded in the SnS₂ by van der Waals force.

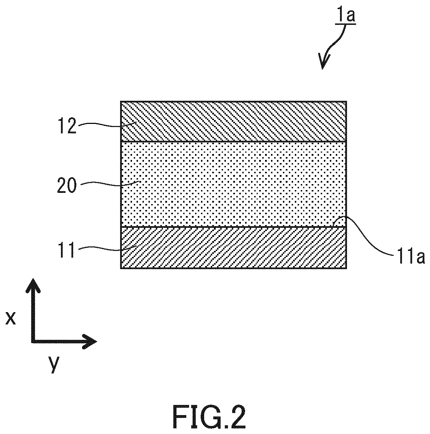

FIG. 2 is a cross-sectional view schematically showing the capacitor 1a according to an embodiment of the present disclosure. The directions indicated by the x and y axes shown in FIG. 2 are respectively the same as those indicated by the x and y axes shown in FIG. 1. As shown in FIG. 2, the capacitor 1a includes a first electrode 11, a second electrode 12, and the dielectric 20. The dielectric 20 is placed, for example, between the first electrode 11 and the second electrode 12 in a particular direction (x axis direction). Specifically, the particular direction is a direction intersecting a surface 11a of the first electrode 11 facing the second electrode 12. The particular direction may be a direction perpendicular to the surface 11a of the first electrode 11 facing the second electrode 12. The dielectric 20 are in contact, for example, with the first electrode 11 and the second electrode 12. A surface of the second electrode 12 extends, for example, in parallel to a surface of the first electrode 11, the surfaces each being in contact with the dielectric 20. With such structural features, the capacitor 1a includes the dielectric 20, and therefore current leakage in the capacitor 1a is likely to be reduced.

The electrical conductivity of the dielectric 20 in the particular direction at 25°C may be less than 2 × 10⁻¹¹ S/cm, 1 × 10⁻¹¹ S/cm or less, or 1 × 10⁻¹⁴ S/cm or less.

The SnS₂ in the second layer 22 is, for example, a single crystal. With such a structural feature, current leakage in the capacitor 1a including the dielectric 20 is likely to be reduced.

The diamine included in the first layer 21 is not limited to a particular diamine as long as the first layer 21 and the second layer 22 are stacked alternately. The diamine is, for example, an alkyldiamine or an aryldiamine. The number of carbon atoms in an alkyl group in the alkyldiamine or an aryl group in the aryldiamine is, for example, 10 or less, and may be 6 or less, 4 or less, or 3 or less. The diamine may include ethylenediamine. In this case, the first layer 21 and the second layer 22 are easily stacked alternately because intercalation of ethylenediamine into SnS₂ is relatively easy.

For example, the second layer 22 is placed at each end of the dielectric 20 in the particular direction.

The materials of the first electrode 11 and the second electrode 12 in the capacitor 1a are not limited to particular materials. The first electrode 11 and the second electrode 12 each include, for example, a metal, an alloy, or an electrically conductive metal compound.

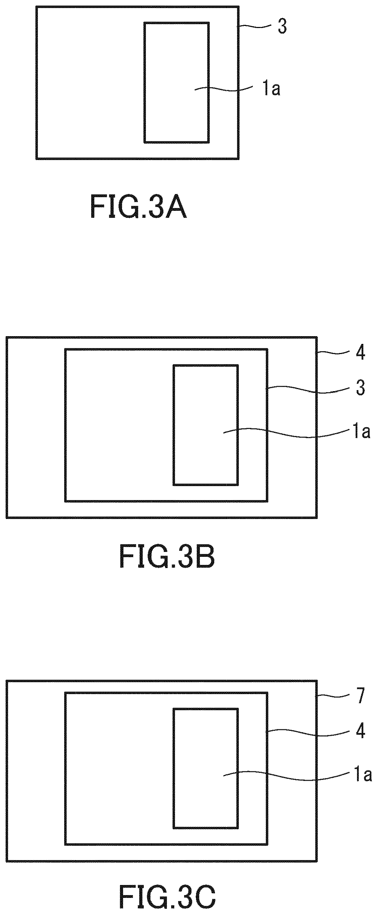

FIG. 3A schematically shows an electrical circuit 3 according to the embodiment of the present disclosure. As shown in FIG. 3A, the electrical circuit 3 includes the capacitor 1a. The electrical circuit 3 is not limited to a particular circuit as long as the electrical circuit 3 includes the capacitor 1a. The electrical circuit 3 may be an active circuit or a passive circuit. The electrical circuit 3 may be a discharging circuit, a smoothing circuit, a decoupling circuit, or a coupling circuit. Since the electrical circuit 3 includes the capacitor 1a, the electrical circuit 3 is likely to have desired properties. For example, it is likely that the capacitor 1a reduces noise in the electrical circuit 3.

FIG. 3B schematically shows a circuit board 4 according to the embodiment of the present disclosure. As shown in FIG. 3B, the circuit board 4 includes the capacitor 1a. The circuit board 4 is not limited to a particular circuit board as long as the circuit board 4 includes the capacitor 1a. The circuit board 4 includes, for example, the electrical circuit 3. The circuit board 4 may be an embedded board or a motherboard.

FIG. 3C schematically shows an apparatus 7 according to the embodiment of the present disclosure. As shown in FIG. 3C, the apparatus 7 includes the capacitor 1a. The apparatus 7 is not limited to a particular apparatus as long as the apparatus 7 includes the capacitor 1a. The apparatus 7 includes, for example, the circuit board 4. The apparatus 7 may be an electronic device, a communication device, a signalprocessing device, or a power-supply device. The apparatus 7 may be a server, an AC adapter, an accelerator, or a flat-panel display such as a liquid crystal display (LCD). The apparatus 7 may be a USB charger, a solid-state drive (SSD), an information terminal such as a PC, a smartphone, or a tablet PC, or an Ethernet switch.

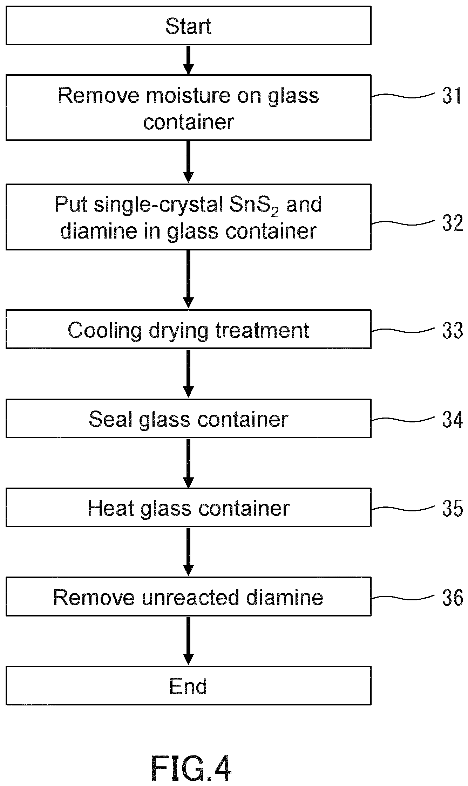

An example of the method for producing the dielectric 20 according to the present embodiment of the present disclosure will be described. FIG. 4 is a flowchart showing an example of a dielectric production method according to the embodiment of the present disclosure.

A step 31 is a step of removing moisture on a glass container. This is performed, for example, by a vacuum desiccation treatment. The vacuum desiccation treatment is a treatment, for example, in which moisture on a glass container is removed in an atmosphere at a pressure lower than the atmospheric pressure. The pressure lower than the atmospheric pressure is, for example, -0.08 MPa or lower in gauge pressure. The vacuum desiccation treatment may include adjusting an environment of the glass container to a pressure of 10 Pa or lower and a temperature of 300°C or higher. In this case, the moisture on the glass container can be prevented from mixing in a diamine such as ethylenediamine. The moisture on the glass may be removed by vacuum drying. That is, the moisture may be removed from the glass container in an atmosphere at a temperature lower than the boiling point of water and at a pressure equal to or lower than vapor pressure.

A surface of glass commonly has moisture thereon. This moisture is released, for example, by heating the glass. According to "Gas emission from quartz glass" reported by Nasu, et al. in Journal of the Illuminating Engineering Institute of Japan, vol. 74, no. 9, pp. 595 to 600, the amount of moisture that can be released is, for example, 6.5 × 10¹⁷ per m². A step of removing moisture on a glass container used is not performed in the course of production of a sample in Non Patent Literature 1. In Non Patent Literature 1, a glass container having an inner diameter of 16 mm and a length of 20 cm is used. When ethylenediamine is added into this glass container to produce a sample, approximately 5.64 × 10⁻³ mmol/liter of water can be mixed in the ethylenediamine. In the dielectric production method according to the present embodiment, for example, the step 31 is performed. This reduces the amount of moisture mixed in a diamine such as ethylenediamine. As a result, the amount of moisture included in the dielectric 20 is likely to be reduced in the production of the dielectric 20.

A step 32 is a step of putting single-crystal SnS₂ and a diamine such as ethylenediamine into the glass container from which the moisture has been removed in the step 31. The step 32 is performed, for example, in an inactive atmosphere such as an argon atmosphere.

A step 33 is a step of performing a cooling drying treatment, for example, of the single-crystal SnS₂ and the diamine in the glass container. The cooling drying treatment is a treatment, for example, in which the single-crystal SnS₂ and the diamine in the glass container are cooled and dried. The cooling drying treatment includes, for example, cooling the single-crystal SnS₂ and the diamine and adjusting an environment of the single-crystal SnS₂ and the diamine to a pressure of 10 Pa or lower. The single-crystal SnS₂ and the diamine may be cooled before the adjustment of the pressure. In the cooling drying treatment, the temperature at which the diamine and the tin(IV) sulfide are cooled is, for example, equal to or lower than the melting point of the diamine. In the case where the diamine is ethylenediamine, the cooling temperature may be 8.5°C or lower, or 8°C or lower. A small amount of moisture in the diamine can be removed by the step 33.

The cooling drying treatment may be a freeze-drying treatment. That is, the single-crystal SnS₂ and the diamine in the glass container may be frozen and the frozen single-crystal SnS₂ and diamine may be dried by sublimating moisture directly. In the freeze-drying treatment, for example, the single-crystal SnS₂ and the diamine are cooled to a temperature equal to or lower than the melting point of the diamine. This can more reliably remove moisture from the diamine and the tin(IV) sulfide. The method for cooling the single-crystal SnS₂ and the diamine in the glass container to a temperature equal to or lower than the melting point of the diamine is not limited to a particular method. The single-crystal SnS₂ and the diamine may be cooled to a temperature equal to or lower than the melting point of the diamine by cooling the glass container containing the single-crystal SnS₂ and the diamine in liquid nitrogen.

A step 34 is a step of sealing the glass container. In the step 34, for example, the glass container is closed by melting a vicinity of an opening of the glass container using a burner. The glass container can thus be sealed hermetically to prevent moisture from entering the glass container.

A step 35 is a step of performing a heating treatment of the glass container. In the step 35, the glass container is heated, for example, in a temperature range of 140°C or higher and 220°C or lower to intercalate the ethylenediamine into the single-crystal SnS₂. The time required by the heating treatment is not limited to a particular time. The time is, for example, 15 minutes or more and 60 minutes or less. The first layer 21 including the diamine and the second layer 22 including the tin(IV) sulfide and stacked alternately with the first layer 21 are formed by the heating treatment. The diamine is thus intercalated between SnS₂ layers to produce the dielectric 20.

A step 36 is a step of removing an unreacted diamine. The method for removing the diamine is not limited to a particular method. Examples of the method include suction filtration, absorption by a hygroscopic agent, evaporative drying by heating, and blow-drying with dry gas.

At least one selected from the group consisting of the steps 31 and 33 is performed in the method for producing the dielectric 20 according to the present embodiment. In this case, moisture is unlikely to enter in the production of the dielectric 20. Consequently, the dielectric 20 which is likely to reduce current leakage can be produced. The step 33 may be omitted in the method for producing the dielectric 20 according to the present embodiment, for example, as long as the step 31 is performed. Even in this case, moisture is unlikely to enter in the production of the dielectric 20, and thus the dielectric 20 which is likely to reduce current leakage can be produced. The step 31 may be omitted in the case where the method for producing the dielectric 20 includes the step 33.

The method for producing the capacitor 1a may further include a step of adding the first electrode 11 and the second electrode 12 to be in contact with the dielectric 20. The dielectric 20 is thus placed between the first electrode 11 and the second electrode 12. The dielectric 20 is produced, for example, by the above method. The dielectric 20 is placed, for example, between the first electrode 11 and the second electrode 12 in the particular direction (x axis direction). That is, the first electrode 11, the dielectric 20, and the second electrode 12 are placed in this order in the particular direction. Here, a stacking direction of the first layer 21 including the diamine and the second layer 22 including the tin(IV) sulfide and stacked alternately with the first layer 21 coincides with a stacking direction of the first electrode 11, the dielectric 20, and the second electrode 12. In other words, the above particular direction is a direction intersecting the first electrode 11 facing the second electrode 12. The capacitor 1a which is likely to reduce current leakage can be obtained by including the dielectric 20 obtained by the above method in the capacitor 1a according to the present embodiment.

The method for adding the first electrode 11 and the second electrode 12 to be in contact with the dielectric 20 is not limited to a particular method. The first electrode 11 and the second electrode 12 may be formed on principal surfaces of the dielectric 20 by a method involving a vacuum technique, plating, coating, or the like. Examples of the method involving a vacuum technique include vacuum deposition, DC sputtering, RF magnetron sputtering, pulsed laser deposition (PLD), atomic layer deposition (ALD), and chemical vapor deposition (CVD).

### EXAMPLES

Hereinafter, the present disclosure will be described in more detail with reference to an example. The example given below is just an example, and the present disclosure is not limited to the example.

### (Example)

One end of a quartz glass tube manufactured by QSIL GmbH was molten using a gas burner to be closed. The quartz glass tube was cut to a length of about 20 cm. A glass container was produced in this manner. The quartz glass tube had an outer diameter of 13 mm and a wall thickness of 1.25 mm. A desiccation treatment was performed by heating the glass container in an environment decompressed to 10 Pa or lower with a rotary pump and having a temperature of about 300°C. According to "Gas emission from quartz glass" reported by Nasu, et al. in Journal of the Illuminating Engineering Institute of Japan, vol. 74, No. 9, pp. 595 to 600, it is assumed that approximately 7.31 × 10⁻⁹ mol of moisture was removed by this desiccation treatment. The glass container having undergone the desiccation treatment was closed with a rubber stopper, and transferred into a glove box filled with an argon atmosphere. Inside the glove box, approximately 0.2 g of single-crystal SnS₂ and 4 milliliters (ml) of ethylenediamine were put in the glass container, which was then closed with a rubber stopper so that external air would not enter. Then, the glass container was taken out of the glove box. The single-crystal SnS₂ used was provided by HQ graphene or 2D semiconductors. The ethylenediamine used was provided by FUJIFILM Wako Pure Chemical Corporation. The grade of the ethylenediamine used was Wako Special Grade.

After cooled in liquid nitrogen, the glass container containing the single-crystal SnS₂ and the ethylenediamine was left in an environment decompressed to 10 Pa or lower with a rotary pump. The boiling point of liquid nitrogen is -196°C. Under the above condition, the vacuum at 10 Pa or lower was maintained for 5 minutes to remove moisture. After that, a vicinity of the opening of the glass container was molten using a burner to close the glass container. Then, the glass container was heated in an environment at 140°C to 220°C to intercalate the ethylenediamine into the single-crystal SnS₂. The reaction product in the glass container was taken out, and an unreacted ethylenediamine was removed to obtain a specimen according to Example.

### (X-ray diffraction measurement)

An X-ray diffraction (XRD) pattern of the specimen according to Example by 2θ/θ scan was obtained using an X-ray diffractometer X'Pert Pro manufactured by PANalytical B.V. Additionally, an XRD pattern of single-crystal SnS₂ was obtained using a specimen in which a plate-shaped single-crystal SnS₂ was on a glass sheet. A Cu-Kα ray was used as an X-ray source, the voltage was adjusted to 45 kV, the current was adjusted to 40 mA, and the scanning speed was adjusted to 12 deg/min. To see positions of X-ray diffraction peaks, an XRD pattern of single-crystal SnS₂ and an XRD pattern of a material obtained by intercalation of ethylenediamine into single-crystal SnS₂ were calculated using RIETAN FP (F. Izumi and K. Momma, Solid State Phenom., 130, 15-20 (2007).).

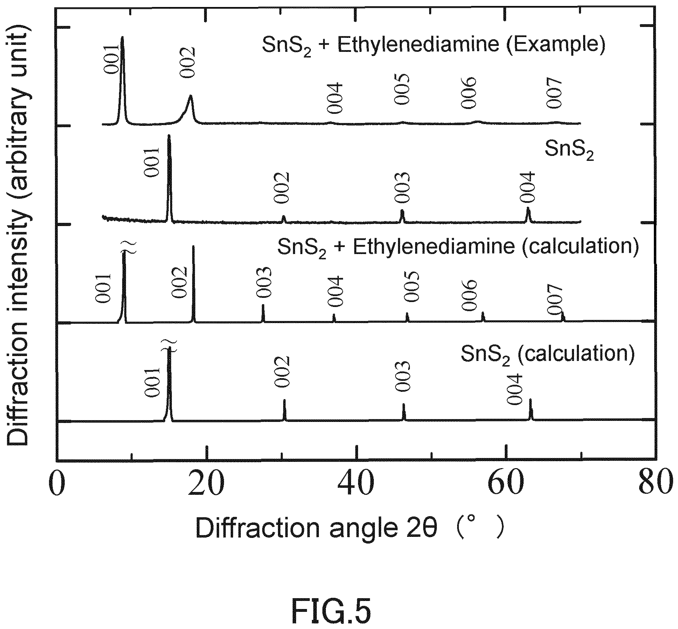

FIG. 5 shows results of measuring and calculating the XRD patterns of the single-crystal SnS₂ and the specimen according to Example. In FIG. 5, the vertical axis represents the diffraction intensity, while the horizontal axis represents the diffraction angle. The XRD pattern shown at the top of FIG. 5 is the XRD pattern of the specimen according to Example. The second XRD pattern from the top of FIG. 5 is the XRD pattern of the single-crystal SnS₂. The second XRD pattern from the bottom of FIG. 5 is the result of calculating the XRD pattern of the material obtained by intercalation of ethylenediamine into single-crystal SnS₂. The XRD pattern shown at the bottom of FIG. 5 is the result of calculating the XRD pattern of the single-crystal SnS₂. According to the result of calculating the XRD pattern, the XRD pattern of the specimen according to Example and the result of calculating the XRD pattern of the material obtained by intercalation of ethylenediamine into single-crystal SnS₂ agree well with each other. This means that the specimen according to Example is a material obtained by intercalation of ethylenediamine into single-crystal SnS₂.

### (FTIR measurement)

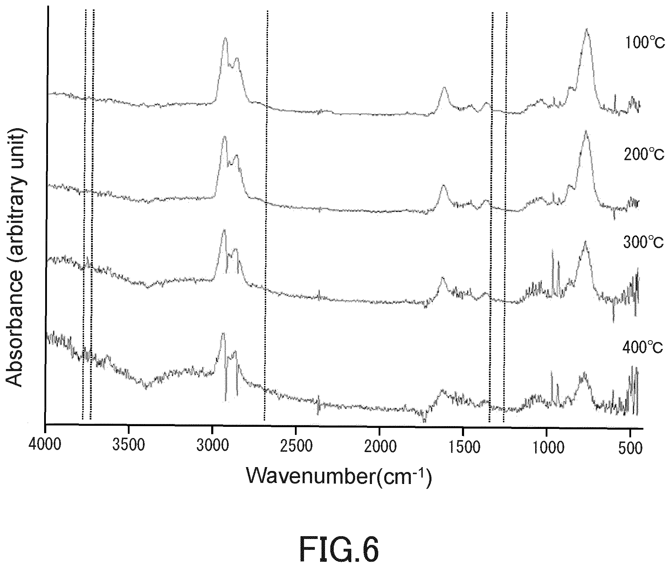

FTIR spectra of gases generated by heating the specimen according to Example were measured using Q600 manufactured by TA Instruments Japan Inc. as a simultaneous differential thermal thermogravimetric analyzer equipped with a Fourier transform infrared (FTIR) spectrophotometer. The specimen according to Example was heated from room temperature to 400°C. FIG. 6 shows FTIR spectra of gases generated by heating the specimen according to Example at 100°C, 200°C, 300°C, and 400°C. In FIG. 6, the vertical axis represents the absorbance, while the horizontal axis represents the wavenumber. In FIG. 6, broken lines parallel to the vertical axis represent positions of peaks derived from H₂S. As shown in FIG. 6, when the specimen according to Example was heated in the range of 100°C to 400°C, peaks derived from ethylenediamine were able to be confirmed around 3000 cm⁻¹ to 2800 cm⁻¹ and around 850 cm⁻¹ to 750 cm⁻¹. This is thought to be due to elimination of the ethylenediamine intercalated in the specimen. Moreover, when the specimen according to Example was heated at 300°C and 400°C, a peak derived from ammonia was confirmed around 1100 cm⁻¹ to 1000 cm⁻¹. The ammonia is thought to have been generated by thermal decomposition of ethylenediamine.

Non Patent Literature 1 states that hydrogen sulfide H₂S was generated at around 200°C and a higher temperature by heating an obtained sample. In Non Patent Literature 1, production of the sample does not involve a treatment for removing moisture on a container used or moisture included in a diamine such as ethylenediamine. This indicates that the residual moisture reacted with sulfur included in SnS₂ to generate H₂S. On the other hand, no peak derived from H₂S was able to be confirmed for the specimen according to Example heated from 100°C to 400°C. This is thought to be because, in Example, the production of the specimen involved the treatments for removing moisture, so that residual moisture in the specimen according to Example was reduced.

### (AC impedance measurement)

The specimen according to Example was sandwiched between an electrode E1 and an electrode E2 to produce a specimen for AC impedance measurement. A four-terminal sample holder SH2-Z manufactured by TOYO Corporation was used as the electrode E1 and the electrode E2. The electrode E1 and the electrode E2 each had a diameter of 2.5 mm. The specimen according to Example had a thickness of 0.53 mm.

An impedance analyzer was configured by combining a frequency response analyzer Model 1260A and a potentiostat Model 1287A manufactured by Solartron Analytical. AC impedance measurement was performed for the specimen for AC impedance measurement using this impedance analyzer. In this measurement, a 100 mV voltage was applied in the frequency range of 10⁻¹ to 10⁵ Hz. The environment temperature was 25°C in this measurement.

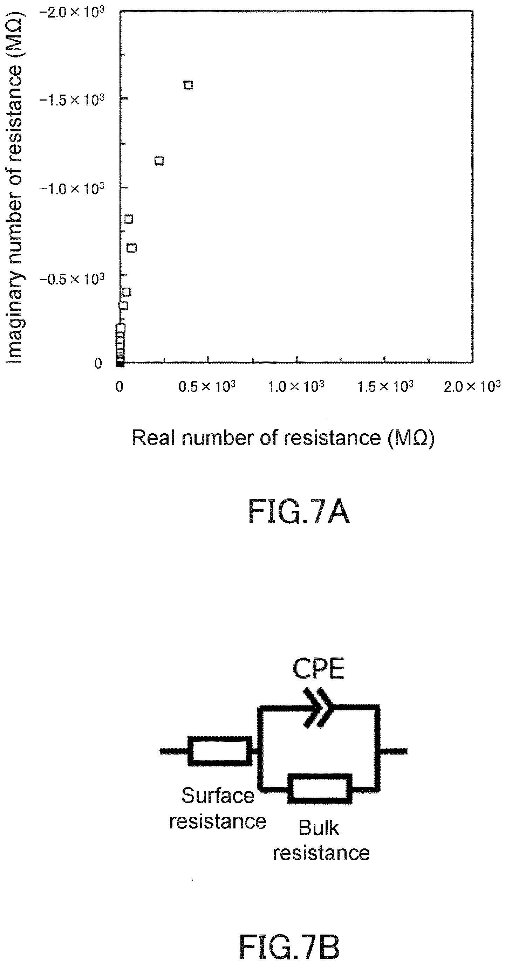

FIGS. 7A and 7B respectively show a Nyquist plot obtained from the result of the AC impedance measurement for the specimen according to Example and an equivalent circuit used for fitting. In FIG. 7A, the vertical axis represents the imaginary number of a resistance, while the horizontal axis represents the real number of the resistance. Additionally, a hollow symbol represents an actual value. Table 1 shows values determined for components by fitting using the equivalent circuit shown in FIG. 7B.

A Nyquist plot of an ideal capacitor is a vertical straight line. On the other hand, when the amount of current leakage increases, a Nyquist plot shows an arc-shaped locus. While the Nyquist plot shown in FIG. 6 of Non Patent Literature 1 shows an arc-shaped locus, the Nyquist plot of the specimen according to Example is linear. While the magnitude of the arc in the Nyquist plot of Non Patent Literature 1 is approximately 25 MΩ, a bulk resistance of the equivalent circuit used for fitting for the specimen according to Example is large, namely, 11.3 GΩ. A large bulk resistance facilitates reduction in current leakage. The above bulk resistance is thought to be because, in Example, the production of the specimen involved the treatments for removing moisture, so that residual moisture in the specimen according to Example was reduced.

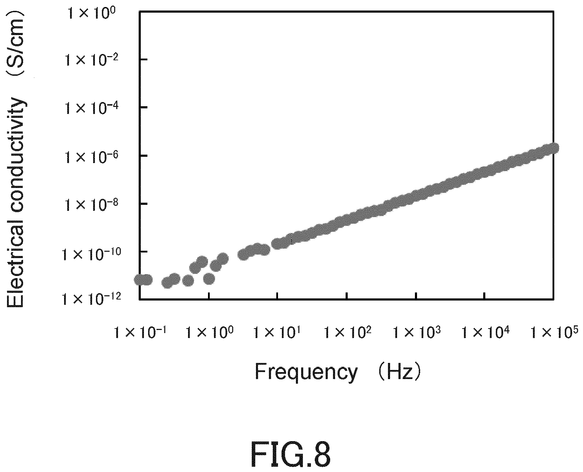

FIG. 8 is a graph showing a relation between an electrical conductivity of the specimen according to Example in a thickness direction thereof and the frequency of the AC voltage. In FIG. 8, the vertical axis represents the electrical conductivity, the horizontal axis represents the frequency. According to FIG. 8, the electrical conductivity of the specimen according to Example is above the lower limit at a frequency of 10⁻¹ Hz. It is understood that an electrical conductivity of the specimen according to Example at 25°C under DC voltage is less than 2 × 10⁻¹¹ S/cm. According to Non Patent Literature 1, a bulk electrical conductivity of the sample at room temperature is approximately 7 × 10⁻⁹ S/cm. Furthermore, according to Wentao Qin, et. al. "A Latent Issue of Via Resistance: Mechanism and Solution." ISTFA 2018: (2018): 121-127, the electrical conductivity of amorphous tantalum oxide Ta₂O₅ used as a dielectric of a capacitor is around 10⁻⁸ S/cm. These facts also conclude that the specimen according to Example considerably reduces current leakage. This is thought to be because the production of the specimen according to Example involved the treatments for removing moisture, so that residual moisture in the specimen according to Example was reduced.

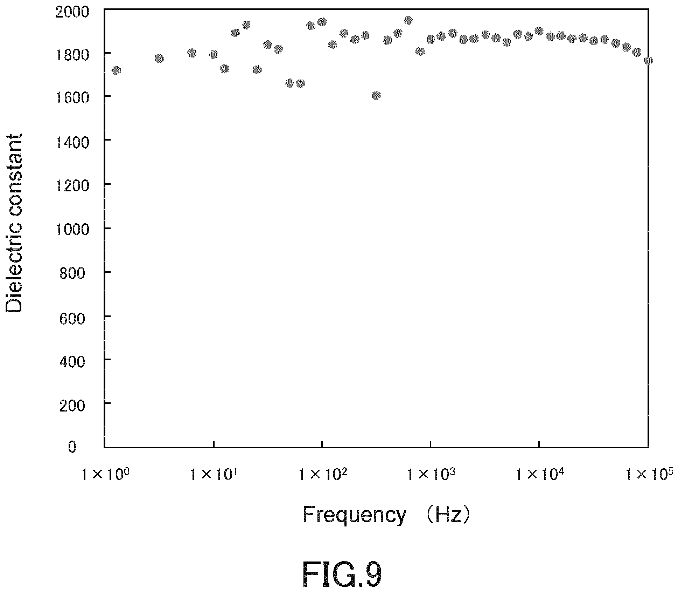

FIG. 9 is a graph showing a relation between a dielectric constant of the specimen according to Example and the frequency of the AC voltage. In FIG. 9, the vertical axis represents the dielectric constant, while the horizontal axis represents the frequency. According to FIG. 9, dielectric relaxation is not confirmed in the frequency range of 1 Hz to 1 × 10⁵ Hz, and the dielectric constant of the specimen according to Example in this frequency range is roughly 1800. This value is comparable with a dielectric constant of BaTiOs used as a dielectric of a capacitor. It is understood that the specimen according to Example is very useful as a dielectric of a capacitor.

**[Table 1]**

| | Example |
|---|---|
| Surface resistance (kΩ) | 2.7 |
| Bulk CPE-T | 1.55 × 10⁻¹⁰ |
| Bulk CPE-P | 0.995 |
| Bulk resistance (GΩ) | 11.3 |
| Bulk capacity (F/m) | 1.56 × 10⁻¹⁰ |

### INDUSTRIAL APPLICABILITY

The capacitor according to the present disclosure is useful in terms of reducing current leakage.

## Claims

1. A capacitor comprising:
a first electrode;
a second electrode; and
a dielectric placed between the first electrode and the second electrode, wherein
the dielectric includes a first layer including a diamine and a second layer including tin(IV) sulfide,
the first layer and the second layer are stacked alternately in a particular direction intersecting a surface of the first electrode facing the second electrode, and
an electrical conductivity in the particular direction at 25°C is 1 × 10⁻¹⁰ S/cm or less.

2. The capacitor according to claim 1, wherein the tin(IV) sulfide is a single crystal.

3. The capacitor according to claim 1 or 2, wherein the diamine includes ethylenediamine.

4. The capacitor according to any one of claims 1 to 3, wherein the first electrode, the dielectric, and the second electrode are placed in this order in the particular direction.

5. A method for producing a capacitor, the method comprising:
obtaining a dielectric by putting a diamine and tin(IV) sulfide in a container and performing a heating treatment of the container to form a first layer including the diamine and a second layer including the tin(IV) sulfide and stacked alternately with the first layer, and
placing the dielectric between a first electrode and a second electrode by adding the first electrode and the second electrode to be in contact with the dielectric, wherein
the method further comprises at least one selected from the group consisting of performing a vacuum desiccation treatment of the container before the diamine and the tin(IV) sulfide are put in the container and performing a cooling drying treatment of the diamine and the tin(IV) sulfide before the heating treatment.

6. The method according to claim 5, wherein the vacuum desiccation treatment includes adjusting an environment of the container to a pressure of 10 Pa or lower and a temperature of 300°C or higher.

7. The method according to claim 5 or 6, wherein the cooling drying treatment includes adjusting an environment of the diamine and the tin(IV) sulfide to a pressure of 10 Pa or lower at a temperature equal to or lower than a melting point of the diamine.

8. The method according to any one of claims 5 to 7, wherein the diamine and the tin(IV) sulfide are cooled to a temperature equal to or lower than a melting point of the diamine in the cooling drying treatment.

9. The method according to any one of claims 5 to 8, wherein a temperature of the container is maintained in a temperature range of 140°C or higher and 220°C or lower for 15 minutes or more and 60 minutes or less in the heating treatment.

10. An electrical circuit comprising the capacitor according to any one of claims 1 to 4.

11. A circuit board comprising the capacitor according to any one of claims 1 to 4.

12. An apparatus comprising the capacitor according to any one of claims 1 to 4.
